# EUROPÄISCHE PATENTANMELDUNG

(11) **EP 3 490 355 A1**
(43) Veröffentlichungstag der Anmeldung: **29.05.2019**
(21) Anmeldenummer: 17204046.1
(22) Anmeldetag: 28.11.2017
(51) Int. Cl.: H05K 7/20

(54) **MODULARER UMRICHTER**

(71) Anmelder: Siemens Aktiengesellschaft, 80333 München (DE)
(72) Erfinder: Danov, Vladimir, 91056 Erlangen (DE); Ippisch, Stephan, 91058 Erlangen (DE); Kraus, Ludwig, 94099 Ruhstorf (DE)

(57) **Zusammenfassung**

Es wird ein modularer Umrichter (1) vorgeschlagen, der eine Kühlplatte (2) zur Anordnung und Kühlung elektrischer Bauelemente (61, 62) umfasst, wobei die Kühlplatte (2) eine Mehrzahl von Kühlkanälen (21) zur Führung eines Kühlfluids aufweist. Erfindungsgemäß weist die Kühlplatte (2) eine mechanische Schnittstelle (42) zum Herstellen einer lösbaren Verbindung mit wenigstens zwei verschiedenen Arten von Rückkühlern (4) auf, wobei mittels der mechanischen Schnittstelle (42) die Rückkühler (4) jeweils einzeln bezüglich des Kühlfluids fluidisch mit den Kühlkanälen (21) der Kühlplatte (2) koppelbar sind.

## Beschreibung

Die Erfindung betrifft einen modularen Umrichter mit einer Kühlplatte zur Kühlung elektrischer Bauelemente des modularen Umrichters.

Typischerweise ergeben sich bei einem Betrieb eines Umrichters Verlustleistungen, welche auf dem begrenzten Wirkungsgrad der verwendeten elektrischen Bauelemente des Umrichters zurückzuführen sind. Die größten Verlustleistungen weisen beispielsweise Wechselrichter, Symmetriewiderstände, Zwischenkreiskondensatoren oder Zusatzkomponenten, beispielsweise Gleichrichter, auf. Die elektrischen Komponenten erfordern folglich eine stetige Abfuhr der durch ihre Verlustleistung erzeugten Wärme (Abwärme), damit die Betriebssicherheit des Umrichters sichergestellt ist.

Der Stand der Technik unterscheidet Luftkühlungen und Flüssigkeitskühlungen. Bei einer Flüssigkeitskühlung wird weiterhin zwischen einer einphasigen und zweiphasigen Kühlung (Verdampfungskühlung) unterschieden. Für eine Flüssigkeitskühlung sind zudem eigens entwickelte Kühlplatten erforderlich, die eine möglichst plane Oberfläche zum Anbringen der elektrischen Bauelemente sowie eine Mehrzahl von Kühlkanälen aufweisen durch welche das Kühlfluid fließt. Hierbei werden unabhängig von der genannten Unterscheidung die zu kühlenden elektrischen Bauelemente des Umrichters auf die Kühlplatte aufgeschraubt, die dann mit dem Kühlfluid im thermischen Kontakt ist.

Bekannt sind Kühlplatten mit planaren Oberflächen und innenliegenden Kühlkanälen. Die Kühlkanäle können hierbei mittels Tiefbohrungen oder mittels eines Einpressens von Rohren in vorab gefräste Nuten hergestellt sein. Weiterhin sind Kühlplatten aus Vergussmasse oder Matten bekannt.

Hieraus ist erkennbar, dass die Kühlplatte an die jeweilige Art der Kühlung angepasst ist. Insbesondere ist ein Austausch zwischen einer Luftkühlung und einer Flüssigkeitskühlung nicht möglich oder mit großem technischem Aufwand verbunden.

Der vorliegenden Erfindung liegt die Aufgabe zugrunde, einen Umrichter bezüglich der Art seiner Kühlung zu flexibilisieren.

Die Aufgabe wird durch einen modularen Umrichter mit den Merkmalen des unabhängigen Patentanspruches 1 gelöst. In den abhängigen Patentansprüchen sind vorteilhafte Ausgestaltungen und Weiterbildungen der Erfindung angegeben.

Der erfindungsgemäße modularer Umrichter umfasst eine Kühlplatte zur Anordnung und Kühlung elektrischer Bauelemente, wobei die Kühlplatte eine Mehrzahl von Kühlkanälen zur Führung eines Kühlfluids aufweist. Erfindungsgemäß weist die Kühlplatte eine mechanische Schnittstelle zum Herstellen einer zerstörungsfrei lösbaren Verbindung mit wenigstens zwei verschiedenen Arten von Rückkühlern auf, wobei mittels der mechanischen Schnittstelle die Rückkühler jeweils einzeln bezüglich des Kühlfluids fluidisch mit den Kühlkanälen der Kühlplatte koppelbar sind.

Als elektrische Bauelemente werden insbesondere alle Komponenten und/oder Bauelemente und/oder Bauteile eines Umrichters angesehen, die während eines Betriebes des Umrichters eine thermische Verlustleistung aufweisen und somit Wärme oder Abwärme erzeugen. Insbesondere werden elektronische Bauelemente ebenfalls als elektrische Bauelemente angesehen.

Erfindungsgemäß weist der modulare Umrichter die mechanische Schnittstelle zum Herstellen einer lösbaren und fluidischen Verbindung mit wenigstens zwei verschiedenen Arten von Rückkühlern auf. Dadurch ist der Rückkühler, der zum Rückkühlen des Kühlfluids erforderlich ist, vorteilhafterweise an die Art der Kühlung anpassbar. Die Schnittstelle stellt für die wenigstens zwei Arten der Rückkühlung den mechanischen sowie fluidischen Kontakt sicher. Vorteilhafterweise ergibt sich dadurch ein modularer Aufbau des erfindungsgemäßen Umrichters, dessen elektrischer Aufbau unabhängig von der Kühlung der zugehörigen elektrischen Bauelemente gestaltbar ist. Die Kühlung beziehungsweise die Art der Kühlung kann demnach an den Anwendungsfall des modularen Umrichters angepasst werden. Mit anderen Worten wird eine modulare Bauweise des Umrichters, das heißt ein modularer Umrichter bereitgestellt. Insbesondere ist hierzu die zerstörungsfreie Lösbarkeit des Rückkühlers bedeutsam, die mittels der erfindungsgemäßen Schnittstelle bereitgestellt wird. Weiterhin sind dadurch ein kostengünstiger Aufbau des modularen Umrichters sowie eine kostengünstiger Umbau des modularen Umrichters in Bezug auf die verwendete Art der Kühlung möglich.

Gemäß einer vorteilhaften Ausgestaltung der Erfindung umfasst der modulare Umrichter wenigstens einen mittels der mechanischen Schnittstelle verbundenen Rückkühler, wobei der Rückkühler einen Kondensator für das Kühlfluid aufweist, und die Kühlkanäle in Verbindung mit dem verbundenen Rückkühler ein Zwei-Phasen-Thermosiphon ausbilden.

Vorteilhafterweise wird dadurch insbesondere eine Siedekühlvorrichtung ausgebildet, das heißt, dass ein Phasenübergang eines Kühlfluids, beispielsweise eine Verdampfung oder ein Sieden eines Kühlfluids, zur Kühlung des Umrichters beziehungsweise seiner elektrischen Bauelemente verwendet wird. Mit anderen Worten wird ein zweiphasengekühlter modularer Umrichter bereitgestellt. Durch das Verdampfen oder Sieden des Kühlfluids (zweiphasige Kühlung) wird weiterhin ein möglichst gleichmäßiges Temperaturprofil über die Kühlplatte ermöglicht.

Zur Abfuhr der Wärme oder Abwärme an die Umgebung des modularen Umrichters kann der Kondensator bevorzugt luftgekühlt und/oder wassergekühlt sein. Mit anderen Worten ist der Rückkühler bevorzugt als wassergekühlter und/oder luftgekühlter Rückkühler ausgebildet.

Besonders bevorzugt ist der Rückkühler als Kondensator ausgebildet, sodass dieser ebenfalls als Kondensator bezeichnet werden kann. Der Rückkühler kann jedoch neben dem Kondensator weitere Elemente, beispielsweise Fluidleitungen zur Führung des Kühlfluids, umfassen.

Ein luftgekühlter Rückkühler wird im Sinne der vorliegenden Erfindung als ein Rückkühler erster Art angesehen. Ein wassergekühlter Rückkühler wird im Sinne der vorliegenden Erfindung als ein Rückkühler zweiter Art angesehen. Insbesondere ist ein Luft-Kühlfluid-Rückkühler (erste Art) oder ein Wasser-Kühlfluid-Rückkühler (zweite Art) vorgesehen. Die mechanische zerstörungsfreie Schnittstelle ermöglicht ein Anschließen der zwei genannten Arten von Rückkühlern, beispielsweise mittels einer Steckverbindung, Schraubverbindung und/oder Klippverbindung. Weiterhin wird mittels der Schnittstelle vorteilhafterweise ein einfacher Wechsel zwischen den zwei Arten von Rückkühlern ermöglicht.

Weiterhin kann der Rückkühler bevorzugt einen Titanwärmetauscher umfassen.

Dadurch wird ein Einsatz des Rückkühlers für schwierige Gewässer, beispielsweise mit einer hohen Salzkonzentration und/oder einer hohen Chloridkonzentration, ermöglicht, da Titan eine hierzu ausreichende Materialbeständigkeit aufweist.

Gemäß einer bevorzugten Ausgestaltung der Erfindung erstrecken sich die Kühlkanäle der Kühlplatte wenigstens teilweise geradlinig und parallel zueinander.

Dadurch wird ein möglichst gleichmäßiges Temperaturprofil über die Kühlplatte ermöglicht. Insbesondere sind die geradlinig sich erstreckenden Kühlkanäle mittels eines Strangpressprofils, insbesondere aus Aluminium, hergestellt. Dadurch ergibt sich ein besonders kostengünstiger Aufbau der Kühlplatte.

Bevorzugt sind die Kühlkanäle hierbei fluidisch parallel mittels einer Querbohrung innerhalb der Kühlplatte verbunden.

Hierbei kann in einem oberen Bereich des Umrichters vor der Schnittstelle und in einem unteren Bereich des Umrichters eine solche Querbohrung vorgesehen sein. Dadurch werden die Kühlkanäle vorteilhafterweise fluidisch gekoppelt. Durch eine Querbohrung vor der Schnittstelle, wobei sich die relativen Begriffe vor oder nach auf eine Strömungsrichtung des dampfartigen oder dampfförmigen Kühlfluids beziehen, wird ein Zusammenführen des Kühlfluids aus den Kühlkanälen vor der Schnittstelle ermöglicht.

In einer vorteilhaften Ausgestaltung der Erfindung weist wenigstens einer der Kühlkanäle in einem dem Kühlfluid zugewandten Oberflächenbereich eine Unebenheit auf.

Dadurch wird vorteilhafterweise das Sieden des Kühlfluids verbessert, da die Unebenheit eine Stelle mit einer verstärkten Keimbildung für das Kühlfluid ausbildet. Weiterhin wird eine turbulente Strömung des Kühlfluids unterstützt, wodurch eine verbesserte Wärmeübertragung zwischen der Kühlplatte und dem Kühlfluid ausgebildet wird.

Gemäß einer vorteilhaften Ausgestaltung der Erfindung weist die Kühlplatte einen ersten Bereich zur Anordnung von Halbleiterbauelementen, insbesondere von IGBT-Modulen, auf, und einen zweiten Bereich zur Anordnung von elektrischen Kondensatoren, wobei zwischen dem ersten und zweiten Bereich eine Schlitzung der Kühlplatte vorgesehen ist.

Die elektrischen Kondensatoren sind vom Kondensator des Rückkühlers, der zum kondensieren des Kühlfluids vorgesehen ist, beziehungsweise vom Rückkühler zu unterscheiden. Die elektrischen Kondensatoren bilden eine elektrische Kapazität aus.

Insbesondere sind wenigstens einer oder mehrere der elektrischen Kondensatoren als Elektrolytkondensator ausgebildet. Durch die Anordnung der elektrischen Kondensatoren auf der Kühlplatte werden diese vorteilhafterweise ebenfalls gekühlt.

Weiterhin sind die elektrischen Kondensatoren durch die Anordnung in dem vom ersten Bereich verschiedenen zweiten Bereich vorteilhafterweise thermisch von den Halbleiterbauelementen wenigstens teilweise entkoppelt. Diese thermische Entkopplung wird vorteilhafterweise durch die Schlitzung der Kühlplatte zwischen den zwei Bereichen weiter verbessert. Mit anderen Worten wird eine Wärmeübertagung, das heißt ein Wärmeeintrag von den Halbleiterbauelementen auf die Kondensatoren, möglichst vermieden.

In einer vorteilhaften Weiterbildung der Erfindung sind die Kühlkanäle der Kühlplatte bezüglich der zwei Bereiche und bezüglich des Kühlfluids fluidisch parallel oder seriell ausgebildet.

Insbesondere ist hierbei eine serielle Ausbildung der genannten Kühlkanäle von Vorteil. Dadurch können Komponenten des modularen Umrichters, die zuerst vom kondensierten Kühlfluid erreicht werden, auf ein niedrigeres Temperaturniveau gebracht werden.

Weitere Vorteile, Merkmale und Einzelheiten der Erfindung ergeben sich aus dem im Folgenden beschriebenen Ausführungsbeispielen sowie anhand der einzigen Zeichnung. Dabei zeigt die einzige Figur einen schematisierten modularen Umrichter gemäß einer Ausgestaltung der Erfindung.

Gleichartige, gleichwertige oder gleichwirkende Elemente können in der Figur mit denselben Bezugszeichen versehen sein.

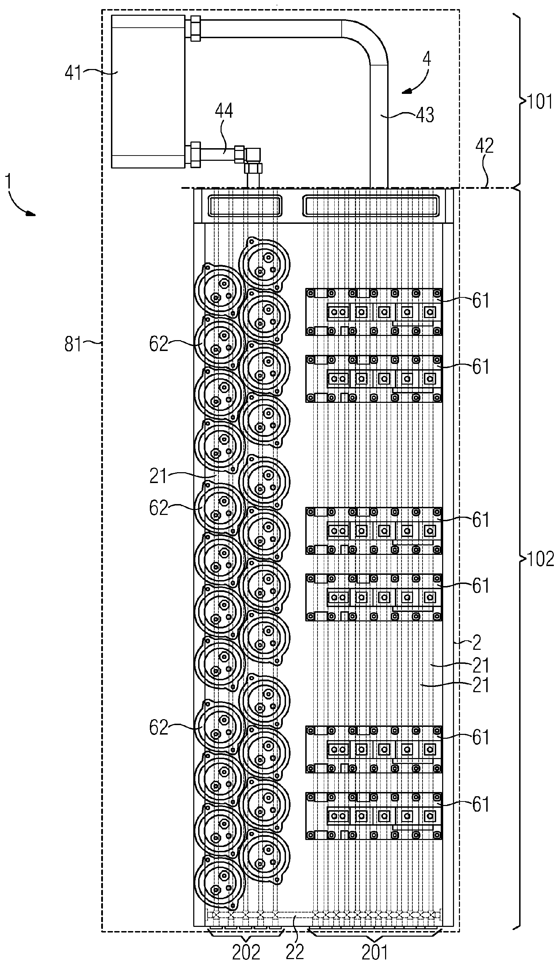

Die Figur 1 zeigt eine schematische Darstellung des modularen Umrichters 1 gemäß einer Ausgestaltung der Erfindung.

Der modulare Umrichter 1 umfasst eine Kühlplatte 2 mit einer Mehrzahl von Kühlkanälen 21, ein Gehäuse 81 sowie einen Rückkühler 4. Der Rückkühler 4 ist mittels einer mechanischen Schnittstelle 42 zerstörungsfrei lösbar mit der Kühlplatte 2 derart verbunden, dass sich eine fluidische Kopplung zwischen dem Rückkühler 4 und den Kühlkanälen 21 der Kühlplatte 2 ausbildet. Hierbei ist der Rückkühler 4 zur Rückkühlung eines in den Kühlkanälen angeordneten und/oder strömenden Kühlfluids vorgesehen.

Weiterhin umfasst der Rückkühler 4 einen Kondensator 41, der zum Kondensieren von verdampften Kühlfluid ausgebildet ist, eine Dampfleitung 43 zum Führen des dampfartigen oder dampfförmigen Kühlfluids zum Kondensator 41 sowie eine Kondensatleitung 44 zum Rückführen des im Kondensator 41 kondensierten Kühlfluids. Der Rückkühler 4 ist über die Dampfleitung 43 und die Kondensatleitung 44 mittels der Schnittstelle 42 zerstörungsfrei lösbar mit den Kühlkanälen 21 der Kühlplatte 2 fluidisch verbunden. In diesem Sinne wird die Schnittstelle durch ein zerstörungsfrei lösbares fluidisches Verbinden der Dampfleitung 43 und der Kondensatleitung 44 mit den Kühlkanälen 21 der Kühlplatte 2 ausgebildet. Dadurch kann ein aufgrund der Abwärme von elektrischen Bauelementen 61, 62 verdampftes Kühlfluid aus den Kühlkanälen 21 zum Kondensator 41 des Rückkühlers 4 geführt werden. Mittels des Kondensators 41 wird das dampfartige oder dampfförmige Kühlfluid kondensiert und dadurch die aufgenommene Abwärme an die Umgebung des modularen Umrichters 1 abgegeben. Das kondensieret Kühlfluid wird mittels der Kondensatleitung 43 und der Schnittstelle 42 wieder zur Kühlplatte 2 rückgeführt, sodass sich ein Kühlkreislauf ausbildet. Insgesamt werden dadurch die elektrischen Bauelemente 61, 62 gekühlt.

Mit anderen Worten ist der modulare Umrichter 1 gemäß der Ausgestaltung der Erfindung in einen Kühlbereich 101 und einen elektrischen Bereich 102 eingeteilt. Der modulare Umrichter 1 umfasst die mechanische zerstörungsfreie Schnittstelle 42, die den Kühlbereich 101 und den elektrischen Bereich 102 des modularen Umrichters 1 funktional, insbesondere fluidisch, miteinander verbindet. Weiterhin ist die mechanische Schnittstelle 42 zum Herstellen der zerstörungsfreien lösbaren Verbindung mit wenigstens zwei verschiedenen Arten von Rückkühlern 4 ausgebildet, wobei mittels der mechanischen Schnittstelle 42 die Rückkühler 4 jeweils einzeln bezüglich des Kühlfluids fluidisch mit den Kühlkanälen 21 der Kühlplatte 2 koppelbar sind. Beispielsweise ist mittels der Schnittstelle 42 eine Verbindung mit einem luftgekühlten Rückkühler (erste Art) und einem wassergekühlten Rückkühler (zweite Art) möglich.

Die elektrischen Bauelemente 61, 62 sind innerhalb des elektrischen Bereiches 102 angeordnet. Der Rückkühler 4 ist innerhalb des Kühlbereiches 101 angeordnet.

Der elektrische Bereich 102 weist wiederum einen ersten Bereich 201 und einen zweiten Bereich 202 auf.

Der erste Bereich 201 umfasst einen Mehrzahl von Halbleiterbauelementen 61, insbesondere eine Mehrzahl von Bipolartransistoren mit isolierter Gate-Elektrode (englisch: Insulated-Gate Bipolar Transistor; abgekürzt: IGBT).

Der zweite Bereich 202 umfasst eine Mehrzahl von elektrischen Kondensatoren 62, insbesondere eine Mehrzahl von Elektrolytkondensator (abgekürzt: Elko). Zwischen dem ersten und zweiten Bereich 201, 202 kann eine nicht dargestellte Schlitzung zur thermischen Entkopplung der zwei Bereiche 201, 202 vorgesehen sein.

Weiterhin erstrecken sich die Kühlkanäle 21 der Kühlplatte 2 geradlinig und parallel zueinander. Die Kühlplatte 2 ist bevorzugt, insbesondere innerhalb des elektrischen Bereiches 102, planar oder eben ausgebildet.

In einem unteren Bereich des modularen Umrichters 1 ist eine Querbohrung 22 vorgesehen, die die Kühlkanäle 21, insbesondere die Kühlkanäle 21 des ersten und zweiten Bereiches 201, 202, fluidisch miteinander koppelt. In einem oberen Bereich des elektrischen Bereiches 101 werden die einzelnen Kühlkanäle 21, beispielsweise wiederum mittels einer Querbohrung, vor der Schnittstelle 42 und somit vor dem Rückkühler 4 zusammengeführt. Hierbei bezieht sich die relative Anordnung vor der Schnittstelle 42 auf eine Strömungsrichtung des dampfartigen oder dampfförmigen Kühlfluids.

Die Kühlkanäle 21 können mittels eines Strangpressprofils, insbesondere aus Aluminium, hergestellt sein. Weiterhin können die Kühlkanäle 21 an ihrer dem Kühlfluid zugwandten Oberfläche eine oder mehrere Unebenheiten aufweisen.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

## Patentansprüche

1. Modularer Umrichter (1), umfassend eine Kühlplatte (2) zur Anordnung und Kühlung elektrischer Bauelemente (61, 62), wobei die Kühlplatte (2) eine Mehrzahl von Kühlkanälen (21) zur Führung eines Kühlfluids aufweist, **dadurch gekennzeichnet, dass** die Kühlplatte (2) eine mechanische Schnittstelle (42) zum Herstellen einer zerstörungsfrei lösbaren Verbindung mit wenigstens zwei verschiedenen Arten von Rückkühlern (4) aufweist, wobei mittels der mechanischen Schnittstelle (42) die Rückkühler (4) jeweils einzeln bezüglich des Kühlfluids fluidisch mit den Kühlkanälen (21) der Kühlplatte (2) koppelbar sind.

2. Modularer Umrichter (1) gemäß Anspruch 1, mit wenigstens einem mittels der mechanischen Schnittstelle (42) verbundenen Rückkühler (4), wobei der Rückkühler (4) einen Kondensator (41) für das Kühlfluid aufweist, und die Kühlkanäle (21) in Verbindung mit dem verbundenen Rückkühler (4) ein Zwei-Phasen-Thermosiphon ausbilden.

3. Modularer Umrichter (1) gemäß Anspruch 2, **dadurch gekennzeichnet, dass** der verbundene Rückkühler (4) als luftgekühlter Rückkühler und/oder als wassergekühlter Rückkühler ausgebildet ist.

4. Modularer Umrichter (1) gemäß Anspruch 2 oder 3, **dadurch gekennzeichnet, dass** der verbundene Rückkühler (4) einen Titanwärmetauscher umfasst.

5. Modularer Umrichter (1) gemäß einem der vorhergehenden Ansprüche, **dadurch gekennzeichnet, dass** die Kühlkanäle (21) der Kühlplatte (2) sich wenigstens teilweise geradlinig und parallel zueinander erstrecken.

6. Modularer Umrichter (1) gemäß Anspruch 5, **dadurch gekennzeichnet, dass** die Kühlkanäle (21) fluidisch parallel mittels einer Querbohrung (22) innerhalb der Kühlplatte (2) verbunden sind.

7. Modularer Umrichter (1) gemäß einem der vorhergehenden Ansprüche, **dadurch gekennzeichnet, dass** wenigstens einer der Kühlkanäle (21) in einem dem Kühlfluid zugewandten Oberflächenbereich eine Unebenheit aufweist.

8. Modularer Umrichter (1) gemäß einem der vorhergehenden Ansprüche, **dadurch gekennzeichnet, dass** die Kühlplatte (2) einen ersten Bereich (201) zur Anordnung von Halbleiterbauelementen, insbesondere von IGBT-Modulen (61), aufweist, und einen zweiten Bereich (202) zur Anordnung von elektrischen Kondensatoren (62), wobei zwischen dem ersten und zweiten Bereich (201, 202) eine Schlitzung der Kühlplatte (2) vorgesehen ist.

9. Modularer Umrichter (1) gemäß Anspruch 8, **dadurch gekennzeichnet, dass** die Kühlkanäle (21) der Kühlplatte (2) bezüglich der zwei Bereiche (201, 202) und bezüglich des Kühlfluids fluidisch parallel oder seriell ausgebildet sind.
